# EUROPÄISCHE PATENTSCHRIFT

(11) **EP 0 384 920 B1**
(45) Veröffentlichungstag und Bekanntmachung des Hinweises auf die Patenterteilung: **19.01.1994**
(21) Anmeldenummer: 89103422.5
(22) Anmeldetag: 27.02.1989
(51) Int. Cl.: H03G 3/20, H04L 25/30

(54) **Schaltungsanordnung zur digitalen Einstellung des Verstärkungsfaktors eines digital einstellbaren Empfangsverstärkers**
Circuit for digitally adjusting the gain of a digitally adjustable receiver amplifier
Circuit pour régler d'une façon numérique dans un récepteur le gain d'un amplificateur

(43) Veröffentlichungstag der Anmeldung: 05.09.1990
(73) Patentinhaber: Siemens Nixdorf Informationssysteme Aktiengesellschaft, 33102 Paderborn (DE)
(72) Erfinder: Aimer, Michael, D-8209 Schlossberg (DE); Besemer, Karl, Dipl.-Ing., D-8033 Planegg (DE)
(74) Vertreter: Fuchs, Franz-Josef, Dr.-Ing.

(56) Entgegenhaltungen:
- EP-A- 0 103 873
- EP-A- 0 128 473
- EP-A- 0 171 643
- EP-A- 0 206 443
- PATENT ABSTRACTS OF JAPAN, Band 9, Nr. 99 (E-311), 27. April 1985; & JP-A-59 224 907 (FUJITSU K.K.) 17-12-1984

## Beschreibung

Die Erfindung betrifft eine Schaltungsanordnung zur digitalen empfangsignalabhängigen Einstellung des Verstärkungsfaktors eines digital einstellbaren adaptiven Empfangsverstärkers gemäß den Merkmalen des Oberbegriffs des Anspruchs 1.

Bei der Datenübertragung zwischen zwei Datenstationen, z.B. zwischen einer Leitstation und einer Folgestation eines Datenstationssystems, unterliegen die übertragenen Daten dem Einfluß der Dämpfungsverzerrung. Die bei der Datenstation ankommenden Daten werden deshalb vor der Weiterverarbeitung so weit verstärkt, daß sie dem optimalen Empfangspegel der Datenstation entsprechen. Der Grad der hierfür notwendigen Verstärkung hängt von der empfangenden Datenstation, von der Länge der Datenübertragungsstrecke und von der durch andere an die Datenübertragungsstrecke angeschlossenen Datenstationen verursachten Belastung der Datenübertragungsstrecke ab. In bekannter Weise werden deshalb nach dem Aufbau bzw. nach einer Veränderung des Datenstationssystems entweder einmalig oder nach jedem Einschalten einer Folgestation die entsprechenden Verstärkungsfaktoren programmgesteuert ermittelt. Beispielsweise werden zur Verstärkungsfaktorermittlung von der Leitstation wiederholt Testdaten an die Folgestationen gesendet, die ihre Empfangsverstärkungen schrittweise solange abändern, bis ein pegelgerechter Empfang gewährleistet ist. In einem weiteren Durchgang werden von der Leitstation abermals Testdaten wiederholt ausgesendet, auf die die Folgestationen dann mit einem Rücksignal antworten, worauf die Leitstation ihre Empfangsverstärkung schrittweise einregelt. Zum Schluß sind in den Folgestationen jeweils ein Verstärkungsfaktor gespeichert, während in der Leitstation jeweils Verstärkungsfaktoren für jeweils eine Folgestation gespeichert sind, die jeweils vor der Datenübertragung zu einer Folgestation einzustellen sind.

Zur Verstärkung der Empfangssignale weisen die Datenstationen digital einstellbare Empfangsverstärker auf, deren Verstärkungsfaktoren wie oben angegeben in einem gesonderten Zeitabschnitt mit großem Steuerungsaufwand programmgesteuert ermittelt werden. Aus der europäischen Patentanmeldung EP-A 0 171 643 ist ein Verfahren und eine Vorrichtung zur Übertragung von Signalen zwischen einer Leitstation und einer Anzahl von Folgestationen bekannt, die die erwähnten digital einstellbaren Empfangsverstärker aufweisen und die die Verstärkungsfaktoren in der beschriebenen Weise während einer gesondert ablaufenden Lernphase ermitteln. Das kostet Zeit, die zur nutzbringenden Datenübertragung fehlt. Während dieser Zeit wird die Datenübertragungsgeschwindigkeit herabgesetzt.

Da nur Datenblöcke mit zuvor bekanntem Pegel sicher von den Datenstationen empfangen werden können, ist ein für Servicezwecke gefordertes Mitlesegerät, das alle auf einer Datenübertragungsstrecke übertragenen Datenblöcke mit im allgemeinen unterschiedlichen und für das Mitlesegerät unbekannten Signalpegeln erfaßt, nicht realisierbar.

Aufgabe der Erfindung ist es, eine Schaltungsanordnung zur digitalen empfangssignalabhängigen Einstellung des Verstärkungsfaktors eines digital einstellbaren Empfangsverstärkers anzugeben, durch die einerseits die mit hohem Steuerungsaufwand verbundene Lernphase zur Einstellung der einzelnen Verstärkungsfaktoren in den einzelnen Datenstationen vermieden und andererseits die Möglichkeit des Mitlesens der Datenübertragung auf einer Datenübertragungsstrecke geschaffen wird.

Diese Aufgabe wird bei einer Schaltungsanordnung der eingangs genannten Art erfindungsgemäß durch die Merkmale des kennzeichnenden Teils des Anspruchs 1 gelöst. Diese Schaltungsanordnung stellt den Verstärkungsfaktor nicht programm- sondern hardewaregesteuert ein. Sie ermöglicht eine derart schnelle, automatische, digitale Verstärkungsregelung, daß auf jeden übertragenen Datenblock gesondert reagiert werden kann. Bei Pegeländerungen hervorrufenden Maßnahmen an einer Datenübertragungsstrecke entfallen die ansonsten gesondert notwendigen besonderen Maßnahmen zur Ermittlung und Einstellung der Verstärkungsfaktoren. Durch die schnelle Reaktionsfähigkeit der Schaltungsanordnung ist insbesondere das für Servicezwecke vorteilhafte Mitlesen auf einer Datenübertragungsstrecke zu jeder Zeit und an jedem Ort möglich.

Die Verstärkungsfaktorermittlung und -einstellung geschieht anhand der bereits für Bitsynchronisationszwecke jedem Datenblock am Anfang mitgelieferten O-Bytes, so daß kein zusätzlicher Vorspann nötig ist. Das Ende eines übertragenen Datenblocks wird mittels einer retriggerbaren monostabilen Kippschaltung festgestellt, die dafür sorgt, daß der jeweils nächste übertragene Datenblock mit der maximal möglichen Verstärkung empfangen wird. Durch die Verwendung von Rückkopplungsschaltnetzen wird erreicht, daß die Schaltschwellen der Vergleichseinrichtungen eine Hysterese aufweisen. Dadurch wird verhindert, daß eventuell vorhandene Oberwellen auf dem Empfangssignal nicht zu einem vorzeitigen Schalten der Vergleichseinrichtungen führen. Das ist insbesondere wichtig, wenn der Signalpegel des Empfangssignals im Grenzbereich der Schaltschwellen liegt. Ein Vorteil der Schaltungsanordnung ist, daß sie für Datenübertragungsverfahren eingesetzt werden kann, die sowohl positive wie auch negative Impulssignale zur Datenübertragung einsetzen.

Aus der jap. Patentanmeldung JP-A 57 162 533 ist zwar bereits eine Schaltungsanordung zur empfangssignalabhängigen digitalen Verstärkungsfaktoreinstellung eines digital einstellbaren adaptiven Empfangsverstärkers bekannt, die, wie der Erfindungsgegenstand auch, eine Vergleichseinrichtung mit einer Zählereinrichtung kombiniert. Die hier verwendete Vergleichseinrichtung ist aber nur einmal vorhanden, so daß diese Schaltungsanordnung nicht für ein Datenübertragungsverfahren geeignet ist, bei dem positive und negative Impulssignale zur Datenübertragung verwendet werden. Ebenso ist keine retriggerbare monostabile Kippschaltung vorgesehen, die das dynamische Verhalten auf der Datenübertragungsstrecke überwacht. Daneben weist die Vergleichseinrichtung kein die Schaltschwelle der Vergleichseinrichtung beeinflussendes Rückkupplungsschaltnetz auf. Schließlich wird die Zählereinrichtung mittels eines Taktgenerators getaktet, wie er beim Erfindungsgegenstand nicht vorkommt.

Vorteilhafte Ausgestaltungen der Erfindung sind Gegenstand von Unteransprüchen.

Nachfolgend wird anhand einer Zeichnung ein Ausführungsbeispiel der Erfindung näher erläutert. Es zeigen:
- FIG 1: Ein Übersichtsschaltbild eines Datenstationssystems mit einer Leitstation und mehreren Folgestationen,
- FIG 2: ein Blockschaltbild der erfindungsgemäßen Schaltungsanordung innerhalb eines adaptiven Empfangsverstärkers einer Datenstation in einem Datenstationssystem nach FIG 1 und
- FIG 3: ein Schaltbeispiel eines Rückkopplungsschaltnetzes innerhalb der erfindungsgemäßen Schaltungsanordnung nach FIG 2.

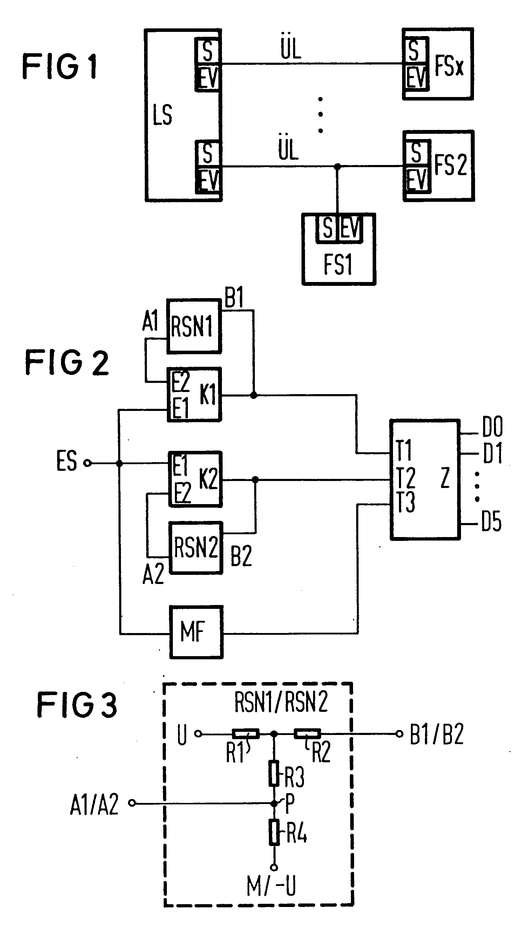

Das in FIG 1 gezeigte Datenstationssystem weist eine Leitstation LS und mehrere Folgestationen FS1 bis FSx auf, die über Übertragungsleitungen ÜL mit der Leitstation LS verbunden sind. Die Übertragungsleitungen ÜL können teilweise auch als Stichleitungen ausgebildet sein. Zum Beispiel ist die erste Folgestation FS1 über eine Stichleitung mit der Leitstation LS verbunden. Die Leitstation LS und die Folgestationen FS1 bis FSx weisen an den Schnittstellen zu den Übertragungsleitungen ÜL Empfangsverstärker EV und Sender S auf. Als Empfangsverstärker werden beispielsweise die aus der europ. Patentanmeldung EP-A 0 171 643 bekannten Empfangsverstärker verwendet.

Auf den Übertragungsleitungen ÜL ist eine fehlerfreie Datenübertragung gewährleistet, wenn die Empfangsverstärker EV die für den jeweiligen Teil der Übertragungsstrecke notwendige Verstärkung aufweisen. Dabei wird für das Ausführungsbeispiel angenommen, daß die zu übertragenden Informationen so übertragen werden, daß binäre Daten 0 abwechselnd ein positives und ein negatives Impulssignal und binäre Daten 1 kein Impulssignal liefern, wobei aber als Impulssignale solche Impulssignale verwendet werden, die eine möglichst geringe Oberwelligkeit, wie z.B. sin²x-förmige Impulssignale, aufweisen. Ferner wird angenommen, daß die Aussendung der Informationen gemäß bekannter Übertragungsverfahren blockweise mit den einzelnen Blöcken zur Bitsynchronisation vorgeschalteten O-Bytes geschieht. Aufgrund des gewählten Übertragungsverfahrens werden die einzelnen O-Bits der O-Bytes mit im Vorzeichen alternierenden Impulssignalen ausgesendet. Diesen Sachverhalt nutzt die nun nachfolgend beschriebene Schaltungsanordnung zur Verstärkungsfaktorermittlung für besagte Empfangsverstärker EV aus.

Die zur Verstärkungsfaktorermittlung maßgebliche Schaltungsanordnung eines Empfangsverstärkers EV ist in FIG 2 zu sehen. Diese Schaltungsanordnung weist zwei Vergleichseinrichtungen K1 und K2 auf, denen jeweils ein Rückkopplungsschaltnetz RSN1 bzw. RSN2 zugeordnet ist. Das erste Paar Vergleichseinrichtung K1 und Rückkopplungsschaltnetz RSN1 ist für ein Empfangssignal ES mit positivem Vorzeichen und das zweite Paar Vergleichseinrichtung K2 und Rückkopplungsschaltnetz RSN2 ist für ein Empfangssignal ES mit negativem Vorzeichen vorgesehen. Die Vergleichseinrichtungen K1 und K2 vergleichen das ankommende Empfangssignal ES jeweils ihrer Zuständigkeit gemäß mit einem positiven bzw. negativen Signalpegel vorgegebener Größe, die jeweils einer Schaltschwelle entsprechen. In Abhängigkeit vom Vergleichsergebnis erzeugen die Vergleichseinrichtungen K1 bzw. K2 ein Ausgangssignal, das zum Fortschalten einer Zählereinrichtung Z dient. Die Ausgangssignale entsprechen dabei entweder dem logischen Wert 0 oder dem logischen Wert 1. Das Ausgangssignal logisch 1 wird von der einen bzw. anderen Vergleichseinrichtung K1 bzw. K2 dann erzeugt, wenn der Signalpegel des Empfangssinals (ES) den positiven bzw. den negativen Vergleichssignalpegel überschreitet.

Die Vergleichseinrichtungen K1 und K2 weisen zu diesem Zweck jeweils einen ersten und zweiten Eingang E1 und E2 auf. An den ersten Eingängen E1 liegt jeweils das Empfangssignal ES an, während an den zweiten Eingängen E2 jeweils ein Vergleichssignal anliegt, daß dem oben angesprochenen positiven bzw. negativen Vergleichssignalpegel entspricht. Das an die Vergleichseinrichtungen K1 und K2 geführte Empfangssignal ES ist bereits durch den Empfangsverstärker EV entsprechend dem im Empfangsverstärker EV im Augenblick eingestellten Verstärkungsfaktor verstärkt.

Die an die zweiten Eingänge E2 der Vergleichseinrichtungen K1 und K2 geführten Vergleichssignale werden von den Rückkopplungsschaltnetzen RSN1 und RSN2 als Ausgangssignale A1 und A2 bereitgestellt. Die Rückkopplungsschaltnetze RSN1 bzw. RSN2 bilden diese Ausgangssignale aus den Ausgangssignalen der Vergleichseinrichtungen K1 bzw. K2, die ihnen als Eingangssignale B1 bzw. B2 zugeführt werden. Dabei nehmen die jeweiligen Ausgangssignale A1 bzw. A2 in Abhängigkeit von den jeweils möglichen beiden Zuständen der Eingangssignale B1 bzw. B2 unter schiedliche Werte an. Damit weist jede Vergleichseinrichtung K1 bzw. K2 zwei verschiedene Schaltschwellen auf, die eine Schalthystere bilden. Aus Symmetriegründen unterscheiden sich die Schaltschwellen zwischen den Vergleichseinrichtungen K1 und K2 nicht dem Betrag nach sondern nur dem Vorzeichen nach.

Parallel zu den beiden Vergleichseinrichtungen K1 und K2 wird eine Zeitsteuerungseinrichtung MF mit dem Empfangssignal ES angesteuert. Die Zeitsteuerungseinrichtung MF weist eine retriggerbare monostabile Kippschaltung auf, die analog zu den Ausgangssignalen der Vergleichseinrichtungen K1 und K2 ein Ausgangssignal Logisch 1 liefert, wenn die Haltezeit der monostabilen Kippschaltung abgelaufen ist. Die Haltezeit ist so bemessen, daß sie kürzer ist als die Zeitdauer zwischen zwei übertragenen Datenblöcken aber länger ist als die Zeitdauer zwischen zwei übertragenen Bitstellen eines Datenblocks. Auf diese Weise wird das Ende eines jeden Datenblocks erkannt und es kann der Verstärkungsfaktor für den nächsten Datenblock auf einen zur Verstärkungsfaktoreinstellung notwendigen Ausgangswert eingestellt werden.

Die Ausgänge der beiden Vergleichseinrichtungen K1 und K2 sowie der Zeitsteuerungseinrichtung MF sind jeweils mit einem von drei Takteingängen T1 bis T3 der Zählereinrichtung Z verbunden. Daneben weist die Zählereinrichtung Z sechs Parallelausgänge D0 bis D5 auf, die nur für das Ausführungsbeispiel auf sechs beschränkt sind. Die Anzahl der Ausgänge hängt von der Anzahl der Eingänge des verwendeten Empfangsverstärkers EV ab. Mit den sechs Parallelausgängen D0 bis D5 können 64 Zählerstände angezeigt werden, von denen nur 16 benützt werden. Das hängt mit der Anzahl der in den beiden zur Bitsynchronisation jedem Datenblock vorangestellten O-Bytes enthaltenen Bitstellen zusammen. Der Unterschied zwischen der Anzahl der möglichen und der tatsächlich verwendeten Zählerstände ist sinnvoll, wenn nichtlineare Verstärkungsverhalten der Empfangsverstärker EV ausgeglichen werden sollen.

Über die Parallelausgänge D0 bis D5 werden Zählerstände ausgegeben, die unmittelbar einen Verstärkungsfaktor bedeuten. Zur Verstärkungsfaktoreinstellung beginnt die Zählereinrichtung Z stets mit dem höchsten Zählerstand und schaltet dann abhängig von den Eingangssignalen an den ersten beiden Takteingängen T1 und T2 schrittweise auf niedrigere Zählerstände um.

Im einzelnen erfolgt die Verstärkungsfaktoreinstellung in folgender Weise: Immer dann, wenn ein Datenblock übertragen wurde und über die Zeitsteuerungseinrichtung MF nach Ablauf der Haltezeit der monostabilen Kippschaltung ein Signal an den dritten Takteingang T3 der Zählereinrichtung Z anliegt, wird die Zählereinrichtung Z auf den höchsten Zählerstand zurückgesetzt. Damit ist für einen neu ankommenden Datenblock die Verstärkung maximal eingestellt. Da ein neuer Datenblock zunächst mit den ihm zur Bitsynchronisation vorangestellten O-Bytes ankommt, wird auf jeden Fall das Impulssignal der ersten Bitstelle des ersten O-Bytes maximal verstärkt. Wenn für den ankommenden Datenblock nicht gerade die maximale Verstärkung benötigt wird, gelangt dieses Impulssignal übersteuert an die Vergleichseinrichtungen K1 und K2. In diesem Fall wird die Schaltschwelle einer der beiden Vergleichseinrichtungen K1 oder K2 überschritten. Diejenige Vergleichseinrichtung, bei der die Schaltschwelle überschritten wird, erzeugt dann ein Ausgangssignal, das die Zählereinrichtung Z veranlaßt, den Verstärkungsfaktor um eine Stufe zu erniedrigen. Aufgrund der Hardwareschaltung geschieht das so schnell, daß das Impulssignal der zweiten Bitstellen des ersten O-Bytes nur mehr mit dem verringerten Verstärkungsfaktor verstärkt wird. Kommt es trotzdem zu einem Überschreiten der Schaltschwelle einer der beiden Vergleichseinrichtungen K1 bzw. K2 wird abermals der Verstärkungsfaktor erniedrigt. Dies geschieht solange, bis entweder der richtige Verstärkungsfaktor eingestellt ist, d.h. eine Schaltschwelle wird nicht mehr überschritten, oder bis der Verstärkungsfaktor nach dem Impulssignal der letzten Bitstelle des zweiten O-Bytes, nach dem sechzehnten Schritt also, den Wert O angenommen hat. In diesem Fall werden die Impulssignale der nachfolgenden Informationsbits nicht verstärkt. In jedem Fall aber ist bis zum Beginn der Informationsbitstellen eines Datenblocks der Verstärkungsfaktor abhängig vom Signalpegel des Empfangssignals ES richtig eingestellt.

In FIG 3 ist ein Schaltbeispiel für die Rückkopplungsschaltnetze RSN1 und RSN2 angegeben. Der prinzipielle Schaltungsaufbau ist für beide Rückkopplungsschaltnetze gleich. Dieser ist durch eine aus vier Widerständen R1 bis R4 aufgebauten T-Schaltung gegeben. Die ersten beiden Widerstände R1 und R2 befinden sich in dem Längsast der T-Schaltung, während sich die beiden zweiten Widerstände R3 und R4 in dem Querast befinden. An dem mit dem ersten Widerstand R1 gebildeten freien Ende des Längsastes ist ein positiver Spannungspotentialanschluß U und an dem mit dem zweiten Widerstand R2 gebildeten freien Ende des Längsastes ist der Signaleingang für eines der Eingangssignale B1 bzw. B2, je nachdem, ob die T-Schaltung das erste Rückkopplungsschaltnetz RSN1 oder das zweiten Rückkopplungsschaltnetz RSN2 bildet, vorgesehen. Am freien Ende des Querastes der T-Schaltung ist entweder ein Massepotentialanschluß M oder ein negativer Spannungspotentialanschluß -U vorgesehen. Zwischen dem dritten und vierten Widerstand R3 und R4 befindet sich ein Mittelabgriff P, der mit einem Signalausgang verbunden ist, über den eines der beiden Ausgangssignale A1 bzw. A2 ausgegeben wird. Für den Massepotentialanschluß M bzw. für den negativen Spannungspotentialanschluß -U sowie für die beiden Ausgangssignale A1 bzw. A2 gilt analog das zu den Eingangssignalen B1 und B2 gesagte.

Die Dimensionierung der einzelnen Widerstände hängt von der Wahl der an den positiven und negativen Spannungspotentialanschlüssen U bzw. -U angelegten Spannungen bzw. von den Signalpegeln der Ein- bzw. Ausgangssignale B1/B2 bzw. A1/A2 ab. Für das Ausführungsbeispiel ist angenommen, daß am positiven Spannungspotentialanschluß U 5 Volt und am negativen Spannungspotentialanschluß -U -5 Volt anliegen. Ferner ist angenommen, daß die Eingangssignale B1 bzw. B2 einen Signalpegel von 0 Volt bzw. von 5 Volt und die Ausgangsignale A1 bzw. A2 von den Eingangssignalen B1 bzw. B2 abhängig jeweils einen Signalpegel von 500 mV und 700 mV bzw. -500 mV und -700 mV aufweisen. Die Widerstände R1 bis R4 weisen dann für das erste Rückkopplungsschaltnetz RSN1 beispielsweise die Werte 270, 820, 6800 und 1200 Ohm und für das zweite Rückkopplungsschaltnetz RSN2 beispielsweise die Werte 1000, 3300, 4700 und 4700 Ohm auf.

## Patentansprüche

1. Schaltungsanordnung zur digitalen empfangsignalabhängigen Einstellung des Verstärkungsfaktors eines digital einstellbaren adaptiven Empfangsverstärkers im Empfangsteil einer Datenstation in einem Datenstationssystem mit wenigstens einer Leitstation und wenigstens einer Folgestation, das für eine blockweise Übertragung von binär codierten Daten gemäß einem Datenübertragungsverfahren ausgelegt ist, bei dem einem Binärwert der binär codierten Daten ein Impulssignal 0 und dem anderen Binärwert ein im Vorzeichen alternierendes Impulssignal zugeordnet ist,
**dadurch gekennzeichnet,** daß eine erste
und zweite Vergleichseinrichtung (K1 bzw. K2) vorgesehen ist, an deren jeweiligen ersten Eingängen (E1) das Empfangssignal (ES) anliegt, daß jeder Vergleichseinrichtung (K1 bzw. K2) ein Rückkopplungsschaltnetz (RSN1 bzw. RSN2) zugeordnet ist, das jeweils zwischen dem Ausgang und einem zweiten Eingang (E2) der jeweils zugehörigen Vergleichseinrichtung (K1 bzw. K2) angeordnet ist, daß der Ausgang der ersten Vergleichseinrichtung (K1) mit einem ersten Takteingang (T1) und der Ausgang der zweiten Vergleichseinrichtung (K2) mit einem zweiten Takteingang (T2) einer Zählereinrichtung (Z) verbunden sind, die Parallelausgänge (D0 bis D5) zur Anzeige eines Zählerstandes aufweist und daß eine Zeitsteuerungseinrichtung (MF) vorgesehen ist, an deren Eingang das Empfangssignal (ES) anliegt und deren Ausgang mit einem dritten Takteingang (T3) der Zählereinrichtung zur Zählerrücksetzung verbunden ist.

2. Schaltungsanordnung nach Anspruch 1,
**dadurch gekennzeichnet,** daß die Zählereinrichtung (Z) als nichtlinearer Zähler ausgebildet ist.

3. Schaltungsanordnung nach Anspruch 1 oder 2,
**dadurch gekennzeichnet,** daß die Zeitsteuerungseinrichtung (MF) wenigstens eine retriggerbare monostabile Kippschaltung aufweist.

4. Schaltungsanordnung nach einem der vorherigen Ansprüche,
**dadurch gekennzeichnet,** daß die Rückkopplungsschaltnetze (RSN1, RSN2) jeweils eine aus Widerständen (R1 bis R4) aufgebaute T-Schaltung aufweisen.

5. Schaltungsanordnung nach Anspruch 4,
**dadurch gekennzeichnet,** daß das eine Ende des Längsastes der T-Schaltung mit einem positiven Spannungspotentialanschluß (U) und das andere Ende dieses Astes mit einem Schaltnetzeingang für ein der zugehörigen Vergleichseinrichtung (K1, K2) zugeordnetes Eingangssignal (B1, B2) verbunden sind und daß der Querast der T-Schaltung einen aus zwei Widerständen (R3, R4) aufgebauten Spannungsteiler mit einem Mittelabgriff (P) aufweist, dessen Mittelabgriff (P) einem Schaltnetzausgang für ein der zugehörigen Vergleichseinrichtung (K1, K2) zugeordnetes Ausgangssignal (A1, A2) und das freie Ende des Querastes der T-Schaltung mit einem Massepotentialanschluß (M) bzw. mit einem negativen Potentialanschluß (-U) verbunden sind.

## Claims

1. Circuit arrangement for the digital reception-signal-dependent adjustment of the gain factor of a digitally adjustable adaptive receive amplifier in the reception part of a data station in a data station system which has at least one control station and at least one secondary station and is designed for a block-by-block transmission of binary coded data in accordance with a data transmission method, in which a pulse signal 0 is assigned to a binary value of the binary coded data and a pulse signal that alternates in operational sign is assigned to the other binary value, characterized in that a first and second comparison means (K1 and K2 respectively) are provided, at the respective first inputs (E1) of which the reception signal (ES) is present, in that assigned to each comparison means (K1 and K2 respectively) is a feedback switching network (RSN1 and RSN2 respectively) which is arranged between the output and a second input (E2) of the respective associated comparison means (K1 and K2 respectively) in each case, in that the output of the first comparison means (K1) is connected to a first clock input (T1) and the output of the second comparison means (K2) is connected to a second clock input (T2) of a counter means (Z) which has parallel outputs (D0 to D5) for indicating a counter reading, and in that a time-control means (MF) is provided, at the input of which the reception signal (ES) is present and the output of which is connected to a third clock input (T3) of the counter means for resetting the counter.

2. Circuit arrangement according to Claim 1, characterized in that the counter means (Z) is designed as a non-linear counter.

3. Circuit arrangement according to Claim 1 or 2, characterized in that the time-control means (MF) has at least one retriggerable monostable flip-flop.

4. Circuit arrangement according to one of the preceding claims, characterized in that the feedback switching networks (RSN1, RSN2) have a T-circuit constructed of resistors (R1 to R4) in each case.

5. Circuit arrangement according to Claim 4, characterized in that one end of the longitudinal branch of the T-circuit is connected to a positive voltage potential terminal (U) and the other end of said branch is connected to a switching network input for an input signal (B1, B2) assigned to the associated comparison means (K1, K2), and in that the transverse branch of the T-circuit has a voltage divider constructed of two resistors (R3, R4) with a centre tap (P), the centre tap (P) of which is connected to a switching network output for an output signal (A1, A2) assigned to the associated comparison means (K1, K2) and the free end of the transverse branch of the T-circuit is connected to a grounded potential terminal (M) or to a negative potential terminal (-U) respectively.

## Revendications

1. Montage pour le réglage numérique, en fonction du signal reçu, du facteur d'amplification d'un amplificateur de réception numériquement adaptatif et réglable, situé dans la partie réception d'un poste de transmission de données dans un système à postes de transmission de données qui comprend au moins un poste pilote et au moins un poste asservi et qui est conçu pour réaliser une transmission par blocs de données codées en binaire conformément à un procédé de transmission de données, selon lequel un signal impulsionnel 0 est associé à une valeur binaire des données codées en binaire et un signal impulsionnel ayant un signe alterné est associé à l'autre valeur binaire,
caractérisé par le fait qu'il est prévu un premier et un second dispositifs comparateurs (K1 et K2), aux premières entrées respectives (E1) desquels est appliqué le signal reçu (ES), qu'à chaque dispositif comparateur (K1 et K2) est associé un réseau contre-réactionné (RSN1 ou RSN2), qui est disposé respectivement entre la sortie et une seconde entrée (E2) du dispositif comparateur associé (K1 ou K2), que la sortie du premier dispositif comparateur (K1) est reliée à une première entrée de cadence (T1) et la sortie du second dispositif comparateur (K2) est reliée à une seconde entrée de cadence (T2) d'un dispositif de comptage (Z), qui comporte des sorties parallèles (D0 à D5) pour l'affichage d'un état de comptage, et qu'il est prévu un dispositif de commande temporelle (MF), à l'entrée duquel est appliqué le signal reçu (ES) et dont la sortie est reliée à une troisième entrée de cadence (T3) du dispositif de comptage pour la remise à l'état initial du compteur.

2. Montage suivant la revendication 1, caractérisé par le fait que le dispositif de comptage (Z) est agencé sous la forme d'un compteur non linéaire.

3. Montage suivant la revendication 1 ou 2, caractérisé par le fait que le dispositif de commande temporelle (MF) comporte au moins un circuit à bascule monostable redéclenchable.

4. Montage suivant l'une des revendications précédentes, caractérisé par le fait que les réseaux contreréactionné (RSN1, RSN2) comportent respectivement un circuit en T constitué de résistances (R1 à R4).

5. Montage suivant la revendication 4, caractérisé par le fait qu'une extrémité de la branche longitudinale du circuit en T est reliée à une borne à potentiel positif de tension (U) et que l'autre extrémité de cette branche est reliée à une entrée du réseau, pour un signal d'entrée (B1,B2) associé au dispositif comparateur concerné (K1,K2), et que la branche transversale du circuit en T comporte un diviseur de tension constitué de deux résistances (R3,R4) et comportant une prise médiane (P), qui est reliée à une sortie du réseau, pour un signal de sortie (A1,A2) associé au dispositif comparateur concerné (K1,K2), et qui relie l'extrémité libre de la branche transversale du circuit en T à une borne (M) appliquant le potentiel de masse ou à une borne à potentiel négatif (-U).
